Europäisches Patentamt

European Patent Office

Office européen des brevets

(19)

(11) Veröffentlichungsnummer: **0 334 347**

**A1**

(12) ## EUROPÄISCHE PATENTANMELDUNG

(21) Anmeldenummer: 89105217.7

(22) Anmeldetag: 23.03.89

(51) Int. Cl.⁴: **C23C 14/34 , H01J 37/34**

(30) Priorität: 25.03.88 DE 3810175

(43) Veröffentlichungstag der Anmeldung:
27.09.89 Patentblatt 89/39

(84) Benannte Vertragsstaaten:
CH DE FR GB LI NL

(71) Anmelder: **ELAN Elektronische Anlagen GmbH**
**Hauptstrasse 57**
**D-6087 Büttelborn 2(DE)**

(72) Erfinder: **Rütt-Hübner, Winfried Peter,**
**Hauptstrasse 57,**
**D-6087 Büttelborn(DE)**

(74) Vertreter: **Patentanwälte Dipl.-Ing. F.W. Möll**
**Dipl.-Ing. H.Ch. Bitterich**
**Langstrasse 5 Postfach 2080**
**D-6740 Landau/Pfalz(DE)**

(54) **Kathodenzerstäubungsvorrichtung.**

(57) Um die Zerstäubungsrate in Kathodenzerstäubungsanlagen steigern zu können, werden die Kühlung und die Überwachung des Targets (6) verbessert. Die topfförmige Kathode (1) mit Zuleitung (2) und Ableitung (3) für Kühlflüssigkeit (4) wird an ihrer Oberseite mit einer dünnen Metallfolie (5) aus gut wärmeleitendem Material verschlossen. Unter der Wirkung des Kühlwasserdrucks auf der einen und des Unterdrucks in der Vakuumglocke (0) auf der anderen Seite schmiegt sich die Folie (5) eng an die Unterseite des Targets (6) an. Um zu verhindern, daß bei einer totalen Zerstäubung des Targets (6) die dünne Folie (5) beschädigt wird, ist ein Überwachungssystem vorgesehen. Dies besteht aus einem System von Nuten (7,8) in Target (6) und Kathode (1), die über eine Meßleitung (9) mit Drossel (11) und angeschlossenem Vakuummeßgerät (10) an Hochvakuum (12) angeschlossen sind.

Fig.1

## Kathodenzerstäubungsvorrichtung

Die Erfindung betrifft eine Vorrichtung zum Abscheiden dünner Schichten mit Hilfe der Kathodenzerstäubung gemäß dem Oberbegriff des Anspruchs 1.

Die spezifische Strom- und Leistungsbelastbarkeit der Kathoden moderner Kathodenzerstäubungsvorrichtungen wird hauptsächlich durch die Effektivität der eingebauten Wasserkühlung bestimmt. Eine weitere Erhöhung der Zerstäubungsrate setzt eine wirksame und verbesserte Abfuhr der gebildeten Wärme voraus.

Ein weiteres Problem derzeitiger Kathodenzerstäubungsvorrichtungen stellt die sichere Erkennung des Endes der Lebensdauer des Targets dar. Das Target besteht üblicherweise aus einem Blech des zu zerstäubenden Materials, welches auf der wassergekühlten Kathode befestigt ist. Es muß verhindert werden, daß in dem Target ein Loch entsteht, da andernfalls das Material der Kathode, meist Kupfer, zerstäubt wird. Dies führt zur Bildung falscher Schichten.

Derzeit wird das Target ausgewechselt, lange bevor ein solches Loch entstanden ist. Das hat eine schlechte Ausnutzung des Targetwerkstoffes zur Folge und bedingt eine hohe Bevorratung.

Der vorliegenden Erfindung liegt die Aufgabe zugrunde, die Produktivität von Zerstäubungskathoden weiter zu verbessern.

Diese Aufgabe wird gelöst durch die kennzeichnenden Merkmale des Anspruchs 1.

Damit ergeben sich die Vorteile, daß Kühlwasser und zu kühlendes Target nur noch durch eine dünne, gut wärmeleitende Folie, beispielsweise aus Kupfer, getrennt sind, wodurch der Wärmewiderstand stark reduziert wird. Unter der Wirkung des Kühlwasserdrucks auf der einen und des Vakuums auf der anderen Seite der Folie wird diese an allen Stellen gleichmäßig fest an das Target gepreßt, wodurch ein optimaler Wärmekontakt zwischen Target und Kühlflüssigkeit hergestellt wird, und zwar auch dann, wenn die Unterseite des Targets nicht exakt eben ist. Die so erreichte Verbesserung der Targetkühlung erlaubt eine Erhöhung der Zerstäubungsleistung und damit eine Verkürzung der Beschichtungszeiten mit entsprechender Steigerung der Produktivität.

Mit der Steigerung der Zerstäubungsrate steigt jedoch auch die Gefahr, daß zuerst in dem Target und sofort anschließend in der dünnen Folie ein Loch entsteht, so daß das Kühlwasser in die Vakuumglocke austreten kann, was äußerst unerwünschte Folgen hat. Um solch dünne, sich an die Rückseite des Targets eng anschmiegende Folien sinnvoll einsetzen zu können, ist eine sichere Überwachung der Lebensdauer des Targets erforderlich.

Dies wird erreicht mit den Merkmalen des Anspruchs 2.

Dank dieser vorteilhaften Weiterbildung der Erfindung können am Vakuummeßgerät drei charakteristische Druckbereiche unterschieden werden:

1. Hochvakuum: Target und Folie sind fehlerfrei.

2. Arbeitsdruck der Vakuumglocke: Das Target wurde bis auf die Nut zerstäubt, das Ende der Lebensdauer des Targets ist fast erreicht, es kann noch eine relativ kurze Zeit gefahrlos weitergearbeitet werden.

3. Erhöhter Druck: Es ist ein Leck zur Wasserkühlung bzw. zur Atmosphäre entstanden.

Es versteht sich, daß Breite und Tiefe der Nut im Target derart ausgebildet sind, daß sie durch die Folie nicht verstopft werden bzw. daß die Folie nicht zerreißt.

Eine vorteilhafte Ausgestaltung der Nuten in Kathode und Target ist Gegenstand des Anspruchs 3.

Um zu verhindern, daß beim Erreichen der Prüfnut das Material der Folie - wenn auch nur kurzfristig bis zum Abschalten der Anlage - zerstäubt wird, empfiehlt sich eine Weiterbildung gemäß Anspruch 4. Eine derartige Zwischenfolie behindert das Vakuumsystem nicht, verhindert jedoch das Abtragen der Kühlfolie.

Eine Alternative zu dem Prüfsystem aus Nuten ist Gegenstand des Anspruchs 5. Der Vorteil dieser Variante besteht darin, daß eine vakuumdichte Verbindung zwischen Kathode und Target entbehrlich ist.

Eine vorteilhafte Weiterbildung der Erfindung, die Gegenstand des Anspruchs 6 ist, erlaubt es, das Arbeitsgas gezielt an jede beliebige Stelle des Targets zu bringen, beispielsweise um dort eine geänderte Gaskonzentration zu erreichen zum Erzielen besonderer Effekte. Auch hierdurch kann der Nutzungsgrad des Targets wesentlich verbessert werden.

Eine Weiterbildung der Erfindung, die der Besserung des Nutzungsgrades durch Forcierung der Kühlung des Targets dient, ist Gegenstand des Anspruchs 7. Hierdurch wird die gesamte Folienfläche gleichmäßig mit turbulent strömender Kühlflüssigkeit beaufschlagt.

Ferner ist es möglich, in den Innenraum der Kathode eine Polplatte, die auf ihrer Oberseite Magnete trägt, drehbar einzusetzen. Die Magnete sind korrosionsgeschützt. Sie modulieren die Erosion des Targets so, daß dieses über eine breite Fläche gleichmäßig abgetragen wird. Dies trägt zu einer weiter verbesserten Ausnutzung des Targets bei.

Die Magnete sind vorteilhafterweise als axial polarisierte, dauermagnetische Ringe ausgebildet, die entweder kreisförmig, kreissektorförmig oder elliptisch geformt und gegebenenfalls dezentrisch auf der Polplatte montiert sind. Auch dies dient dem Zweck, das Target optimal auszunutzen.

Die Zone, wo das Target abgetragen wird, rotiert mit dem rotierenden Magnetfeld. Sie kann daher gezielt auf bestimmte Stellen des Targets gelenkt werden. Ist das Target aus Sektoren unterschiedlicher Materialien zusammengesetzt, kann so das Legierungsverhältnis der fertigen Schicht gezielt gesteuert werden.

Anhand der Zeichnung soll die Erfindung in Form eines Ausführungsbeispiels näher erläutert werden. Es zeigen

Fig. 1 einen Querschnitt durch eine erste Kathode einer Kathodenzerstäubungsvorrichtung,

Fig. 2 eine Draufsicht auf die Anordnung der Fig. 1,

Fig. 3 einen Querschnitt durch eine zweite Kathode und

Fig. 4 eine Draufsicht auf die Kathode der Fig. 3.

Wie die Figuren zeigen, besteht die Kathode 1 aus einem topfförmigen Gefäß mit Zuleitung 2 und Ableitung 3 für das Kühlwasser 4. Die Oberseite der Kathode 1 ist mit Hilfe einer dünnen Folie 5 aus einem gut wärmeleitenden Material, beispielsweise Kupfer, dicht verschlossen. Über die Folie 5 ist das eigentliche Target 6 gelegt. Die gesamte Vorrichtung befindet sich in einer in der Zeichnung nur angedeuteten Vakuumglocke 0.

Unter der Wirkung des Kühlwasser 4 auf der Unterseite und des Kathodenzerstäubungs-Arbeitsdrucks auf der Oberseite schmiegt sich die Folie 5 überall eng an die Unterseite des Targets 6 an, wodurch der Wärmeübergang zwischen Target 6 und Kühlwasser 4 optimal wird.

In den mit Wasser 4 gefüllten Innenraum der Kathode 1 ist ein Kühlmittelverteiler 13 mit Anpassungstrichter 14 zum gleichmäßigen Verteilen der Kühlflüssigkeit entlang der Folie 5 eingesetzt. Der Anpassungstrichter 14 ist so dimensioniert, daß die radiale Komponente der Strömungsgeschwindigkeit der Kühlflüssigkeit wenigstens gleich bleibt, so daß alle Teile der Folie 5 turbulent angeströmt werden.

Um zu verhindern, daß bei einem Loch im Target 6 auch die dünne Folie 5 beschädigt wird, was ein sofortiges Austreten des Kühlwassers 4 in die Vakuumglocke 0 zur Folge hätte, ist ein Vakuumüberwachungssystem eingesetzt. Dieses besteht zunächst aus einem System von Nuten 7, 8 in Target 6 und Kathode 1. Diese Nuten 7, 8 sind so angeordnet, daß sie sich an wenigstens einer Stelle 7' kreuzen. Im vorliegenden Fall ist die Nut 8 in der Kathode 1 kreisringförmig, die Nut 7 in der Unterseite des Targets 6 diametral ausgebildet.

Über eine Meßleitung 9 mit eingesetzter Drossel 11 steht das Überwachungssystem 7, 7', 8 mit Hochvakuum 12 in Verbindung. An einem an die Meßleitung 9 angeschlossenen Vakuummeßgerät 10 kann abgelesen werden, ob der Druck im Nutsystem 7, 8 dem Hochvakuum entspricht, daß also Target 6 und Folie 5 in Ordnung sind, ob der Druck dem Arbeitsdruck in der Vakuumglocke 1' entspricht, was bedeutet, daß das Target 6 bis auf die Nut 7 zerstäubt ist und ausgewechselt werden muß, oder aber einem höheren Druck entspricht, was bedeutet, daß entweder die Folie 5 oder aber die Meßleitung 9 beschädigt sind.

Mit der vorliegenden Erfindung kann durch die verbesserte Kühlung und durch die verbesserte Überwachung des Targets 6 die Produktivität gesteigert werden.

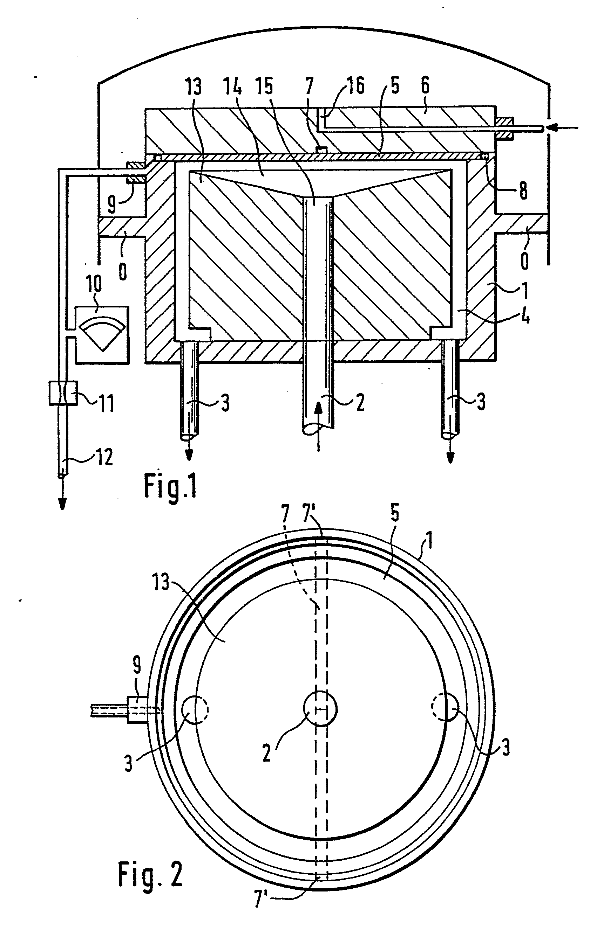

Wie Fig. 1 zeigt, können im Target 6 Bohrungen 16 mit einer Öffnung zum Kathodenzerstäubungsraum eingebracht werden, über die Arbeitsgas gezielt an jede Stelle des Targets gebracht werden kann, um über eine örtliche Änderung der Gaskonzentration bestimmte Effekte erzielen zu können.

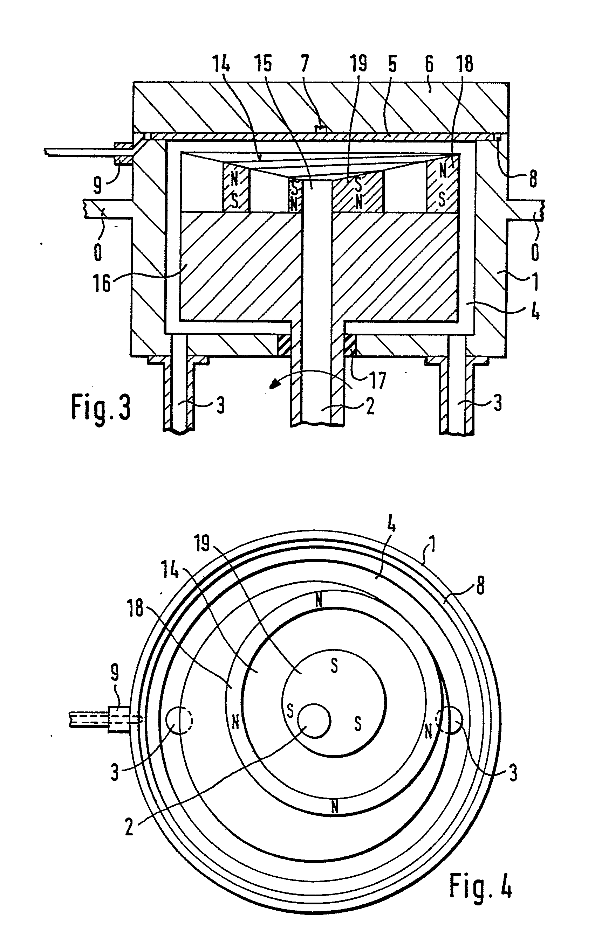

Bei der Ausführungsform der Fig. 3 und 4 ist der Verdrängungskörper 13 durch eine drehbare Magnetanordnung (16 ... 19) ersetzt worden, um einen Magnetron-Betrieb zu erhalten.

Eine Polplatte 16 ist mittels Dichtung 17 in die Kathode 1 drehbar eingesetzt. Sie trägt zwei Ringe 18, 19 von axial polarisierten Dauermagneten. Diese Ringe 18, 19 sind in dem gezeichneten Beispiel dezentrisch auf der Polplatte 16 montiert, damit das rotierende Magnetfeld eine breitflächige Abtragung des Targets 6 gewährleistet. Die Form der magnetischen Ringe 18, 19 kann zum Beispiel auch kreissektorförmig oder elliptisch sein. Mit Hilfe des Magnetfeldes können die Lage und die Breite der Zone, wo das Target 6 abgetragen wird, gezielt gesteuert werden. Besteht das Target 6 aus Sektoren von unterschiedlichen Materialien, kann die Zusammensetzung der Legierung gezielt beeinflußt werden.

Wie die Fig. 3 zeigt, können die Magnete 18, 19 ebenfalls mit dem Anpassungstrichter 14 zur gleichmäßigen Anströmung der Folie 5 ausgeführt werden.

**Ansprüche**

1. Vorrichtung zum Abscheiden dünner Schichten mit Hilfe der Kathodenzerstäubung, umfassend eine Kathode (1), die mittels Kühlflüssigkeit (4) gekühlt und auf ihrer Oberseite mit einem Target (6) belegt ist, wobei die Kathode (1) in einer mit Gas von reduziertem Druck gefüllten Vakuumglok-

ke (0) angeordnet ist, dadurch gekennzeichnet, daß zwischen Kühlwasser (4) und Target (6) eine dünne Folie (5) aus einem gut wärmeleitenden Material angeordnet ist.

2. Vorrichtung nach Anspruch 1, dadurch gekennzeichnet, daß das Target (6) mit der Kathode (1) vakuumdicht verbunden ist, daß in die Unterseite des Targets (6) und in die Oberseite der Kathode (1) wenigstens je eine Nut (7, 8) eingebracht ist, wobei beide Nuten (7, 8) an wenigstens einer Stelle (7') miteinander in Verbindung stehen, und daß die Nuten (7, 8) über eine Meßleitung (9) mit eingesetzter Drossel (11) und angeschlossenem Vakuummeßgerät (10) an Hochvakuum (12) angeschlossen sind.

3. Vorrichtung nach Anspruch 2, dadurch gekennzeichnet, daß die Nut (8) in der Kathode (1) kreisringförmig, die Nut (7) im Target (6) radial bis strahlenförmig ausgebildet ist.

4. Vorrichtung nach Anspruch 2 oder 3, dadurch gekennzeichnet, daß zwischen Target (6) und Folie (5) eine Zwischenfolie aus Targetmaterial eingelegt ist.

5. Vorrichtung nach Anspruch 1, dadurch gekennzeichnet, daß in das Target (6) Bohrungen (16) parallel zur Oberfläche eingebracht sind.

6. Vorrichtung nach Anspruch 1, dadurch gekennzeichnet, daß ein System von Nuten oder Bohrungen (16) vorgesehen ist, die einen Auslaß zum Zerstäubungsraum besitzen und an eine Arbeitsgasquelle angeschlossen sind.

7. Vorrichtung nach Anspruch 1, dadurch gekennzeichnet, daß in den mit Wasser (4) gefüllten Innenraum der Kathode (1) ein Kühlmittelverteiler (13) eingesetzt ist, dessen zur Folie (5) benachbarte Oberfläche (14) so dimensioniert ist, daß die radiale Komponente der Strömungsgeschwindigkeit der Kühlflüssigkeit (4) wenigstens konstant bleibt.

8. Vorrichtung nach Anspruch 1 oder 7, dadurch gekennzeichnet, daß in den mit Wasser (4) gefüllten Innenraum der Kathode (1) eine Polplatte (16) drehbar eingesetzt ist, und daß die Polplatte (16) auf ihrer Oberseite Magnete (18, 19) trägt.

9. Vorrichtung nach Anspruch 8, dadurch gekennzeichnet, daß die Magnete (18, 19) als axial polarisierte Dauermagnet-Ringe ausgebildet sind.

10. Vorrichtung nach Anspruch 8 oder 9, dadurch gekennzeichnet, daß die Dauermagnete (18, 19) kreisförmig, kreissektorförmig bzw. elliptisch sind.

Fig.1

Fig. 2

Fig. 3

Fig. 4

| Europäisches Patentamt | EUROPÄISCHER RECHERCHENBERICHT | Nummer der Anmeldung |

| EINSCHLÄGIGE DOKUMENTE | | | EP 89105217.7 | |
|---|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) | |
| A | EP - A2/A3 - O 144 572 (LEYBOLD--HERAEUS GMBH) <br><br> + Anspruch 1; Fig. 4; Seite 22, Zeile 12 - Seite 23, Zeile 24 + <br><br> -- | 1,2,8 | C 23 C 14/34 <br><br> H O1 J 37/34 | |
| A | DE - A1 - 2 447 280 (TRIPLEX SAFETY GLASS CO. LTD.) <br><br> + Anspruch 1; Seite 11, Zeile 12 - Seite 12, Zeile 6; Fig. 2 + <br><br> -- | 1,2 | | |
| A | DE - A1 - 3 519 907 (BALZERS HOCH-VAKUUM GMBH) <br><br> + Seite 7, Zeilen 5-21; Fig. 1 + <br><br> ---- | 1,2 | | |
| | | | RECHERCHIERTE SACHGEBIETE (Int. Cl 4) | |
| | | | C 23 C 14/00 <br><br> H O1 J 37/00 | |
| Der vorliegende Recherchenbericht wurde für alle Patentansprüche erstellt. | | | | |
| Recherchenort <br> WIEN | Abschlußdatum der Recherche <br> 16-06-1989 | | Prüfer <br> DUNGLER | |